# FASCICULE DE BREVET EUROPEEN

(11) **EP 2 979 341 B1**
(45) Date de publication et mention de la délivrance du brevet: **18.08.2021**
(21) Numéro de dépôt: 14718648.0
(22) Date de dépôt: 04.03.2014
(51) Int. Cl.: G01R 31/08, H02G 9/02, E21B 33/038, E21B 41/04

(54) **PROCEDE DE LOCALISATION DE DEFAUT ELECTRIQUE DANS UN SYSTEME MODULAIRE DE DISTRIBUTION ELECTRIQUE SOUS-MARIN**
VERFAHREN ZUR ORTUNG EINES ELEKTRISCHEN FEHLERS IN EINEM MODULAREN UNTERWASSER-STROMVERTEILUNGSSYSTEM
METHOD FOR LOCATING AN ELECTRICAL DEFECT IN AN UNDERWATER ELECTRICAL DISTRIBUTION MODULAR SYSTEM

(30) Priorité: 29.03.2013 FR 1352922
(43) Date de publication de la demande: 03.02.2016
(73) Titulaire: Schneider Electric Industries SAS, 92500 Rueil-Malmaison (FR)
(72) Inventeur: HAZEL, Terence, F-38050 Grenoble Cedex 09 (FR)
(74) Mandataire: Colette, Marie-Françoise
(86) Numéro de dépôt international: PCT/FR2014/050481
(87) Numéro de publication internationale: WO 2014/154967

(56) Documents cités:
- US-A1- 2009 288 836
- BAERD HENRI ET AL: "Ormen Lange Subsea Compression Station pilot", PCIC EUROPE 2010 CONFERENCE RECORD, IEEE, PISCATAWAY, NJ, USA, 15 juin 2010 (2010-06-15), pages 1-9, XP031717636, ISBN: 978-1-4244-6968-0

## Description

### DOMAINE TECHNIQUE

Le domaine de l'invention est celui des systèmes modulaires de distribution électrique sous-marins. L'invention concerne plus précisément la localisation de défauts électriques dans de tels systèmes.

### ÉTAT DE LA TECHNIQUE ANTÉRIEURE

Un équipement sous-marin d'un système de distribution électrique est installé sur le lit de l'océan à une profondeur qui peut atteindre jusqu'à 10000 pieds, soit plus de 3000 mètres. L'accès à un tel équipement n'est possible qu'avec un véhicule sous-marin téléguidé (ou ROV selon l'expression anglo-saxonne consacrée « *Remotely Operated Vehicle* »). Dès lors, les solutions utilisées pour les installations électriques de surface ne peuvent que très rarement être utilisées pour les installations électriques sous-marines. C'est le cas notamment des solutions de localisation de défauts électriques.

Un équipement sous-marin prend généralement la forme d'un module en ce sens qu'il est logé dans une enceinte relativement petite, ce qui permet d'en limiter le poids à quelques tonnes et les dimensions à moins de 6 mètres afin de faciliter son installation et sa récupération. Des modules de poids et de taille plus importants, comme par exemple 200 tonnes et 17 mètres de long, restent également concernés par l'invention.

Les différents modules qui composent un système modulaire de distribution électrique sous-marin sont interconnectés au moyen de câbles sous-marins. Afin de permettre la séparation des différents modules sur le lit de l'océan, des connecteurs électriques raccordables sous l'eau (« *wet mate connectors* » selon la terminologie anglo-saxonne consacrée) sont utilisés. Ceci permet à chaque module de pouvoir être isolé et ainsi de pouvoir être individuellement récupéré. Un tel système modulaire de distribution électrique est connu de BAERD HENRI ET AL: "Ormen Lange Subsea Compression Station Pilot", PCIC EUROPE 2010 CONFERENCE RECORD, IEEE, PISCATAWAY, NJ, USA, 15 juin 2010, pages 1-9, XP031717636, ISBN: 978-1-4244-6968-0.

On cherche d'une manière générale à disposer d'une solution pour localiser de quel côté d'un connecteur électrique raccordable sous l'eau un défaut électrique s'est produit.

Des solutions de localisation de défaut électrique ont été proposées qui consistent à inclure des transformateurs de courant additionnels à l'extérieur des enceintes pour détecter l'écoulement d'un courant de faute induit par le défaut électrique. Mais les transformateurs de courant additionnels et le câblage délicat associé sont alors exposés à l'eau de mer et aux débris qui s'y trouvent, ce qui engendre des modes de défaillance additionnels qui peuvent réduire la disponibilité globale du système de distribution électrique sous-marin. Des pénétrateurs sont en outre nécessaires pour connecter les transformateurs de courant additionnels à des dispositifs capables de détecter le courant de faute. Or ces pénétrateurs augmentent le risque d'une fuite d'eau de mer dans les enceintes sous-marines, réduisant de faite la disponibilité du système.

Plus généralement, les solutions de localisation et/ou monitorage de défaut électrique pour les installations sous-marines imposent la mise en place de composants additionnels dédiés : voir aussi US 2009/0288836.

### EXPOSÉ DE L'INVENTION

L'invention a pour objectif de proposer une solution de localisation de défaut électrique dans un système modulaire de distribution électrique sous-marin qui ne présente pas les inconvénients suscités. A cet effet, l'invention propose un procédé de localisation de défaut électrique dans un système modulaire de distribution électrique sous-marin comprenant une ligne de puissance le long de laquelle sont disposés :
- un module sous-marin de tête de ligne comprenant un disjoncteur et un relais de protection configuré pour détecter un défaut électrique en aval du disjoncteur sur la ligne ;
- un module sous-marin de terminaison de ligne ;
- optionnellement, un ou plusieurs modules sous-marins intermédiaires en série entre le module sous-marin de tête de ligne et le module sous-marin de terminaison de ligne ;
- un ensemble de connecteurs électriques raccordables sous l'eau permettant d'assurer la connexion électrique des modules sous-marins le long de la ligne, un connecteur mâle et un connecteur femelle assurant la connexion électrique entre deux modules sous-marins consécutifs le long de la ligne,
le procédé comprenant les étapes suivantes mises en œuvre après ouverture du disjoncteur du module sous-marin de tête de ligne suite à la détection d'un défaut électrique en aval sur la ligne :
a) déconnexion par un véhicule sous-marin téléguidé du connecteur mâle et du connecteur femelle assurant la connexion électrique entre deux modules sous-marins consécutifs sur la ligne ;
b) mise en place d'un bouchon diélectrique sur le connecteur mâle déconnecté du connecteur femelle par un véhicule sous-marin téléguidé ;
c) fermeture du disjoncteur du module sous-marin de tête de ligne ;
d) vérification d'une détection d'un défaut sur la ligne en aval du disjoncteur du module de tête de ligne.

Certains aspects préférés mais non limitatifs de procédé sont les suivants :
- l'étape a) comprend la déconnexion du connecteur mâle et du connecteur femelle assurant la connexion électrique entre le module sous-marin de terminaison de ligne et le module sous-marin qui lui est situé directement en amont sur la ligne ;
- le module sous-marin situé directement en amont sur la ligne du module sous-marin de terminaison de ligne est un module sous-marin intermédiaire ;
- lorsque l'étape d) conclut à la présence d'un défaut sur la ligne en aval du disjoncteur du module de tête de ligne, on réitère les étapes a) à d) en substituant ledit module sous-marin intermédiaire au module sous-marin de terminaison de ligne pour venir déconnecter ledit module sous-marin intermédiaire du module sous-marin qui lui est situé directement en amont sur la ligne ;
- les étapes a) à d) sont réitérées tant que l'étape d) conclut à la présence d'un défaut sur la ligne en aval du disjoncteur du module de tête de ligne en venant à chaque itération substituer au module sous-marin intermédiaire le module sous-marin qui lui est situé directement en amont sur la ligne ;
- il comprend avant réitération des étapes a) à d), le retrait du bouchon diélectrique mis en place sur le connecteur mâle lors de l'étape b) et la reconnexion du connecteur mâle et du connecteur femelle déconnectés lors de l'étape a).
- il comprend entre les étapes a) et b) une étape consistant à amener le connecteur femelle d'une position de déconnexion en alignement dans laquelle le connecteur femelle est désengagée du connecteur mâle en alignement avec celui-ci vers une position de déconnexion distante.
- l'étape b) est réalisée par un véhicule sous-marin téléguidé.

De préférence, l'invention est appliquée et concerne un dispositif de connexion de câble à terminaison par connecteur femelle pour système modulaire de distribution électrique sous-marin, comprenant :
- un châssis ;
- une platine de support de terminaison de câble comprenant une portion fixe liée au châssis et une portion mobile pouvant être déplacée en translation relativement au châssis de manière à pouvoir déplacer le connecteur femelle entre une position de service dans laquelle le connecteur femelle et un connecteur mâle sont connectés et une position de déconnexion en alignement dans laquelle le connecteur femelle est désengagée du connecteur mâle en alignement avec celui-ci ;
- un support de châssis manœuvrable pour permettre le déplacement du connecteur femelle entre la position de déconnexion en alignement et une position de déconnexion distante.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- la figure 1 est un schéma illustrant un système de distribution électrique sous-marin ;
- la figure 2 est un schéma illustrant une ligne de puissance d'un système de distribution électrique sous-marin dans laquelle un défaut électrique peut être localisée au moyen du procédé selon l'invention ;
- la figure 3 illustre la mise en place par un véhicule sous-marin téléguidé d'un bouchon diélectrique sur un connecteur mâle ;
- les figures 4-6 représentent les différentes positions pouvant être adoptées par une unité de connexion de câble à terminaison par connecteur femelle conforme à un mode de réalisation possible d'un second aspect de l'invention.

### EXPOSÉ DÉTAILLÉ DE MODES DE RÉALISATION PARTICULIERS

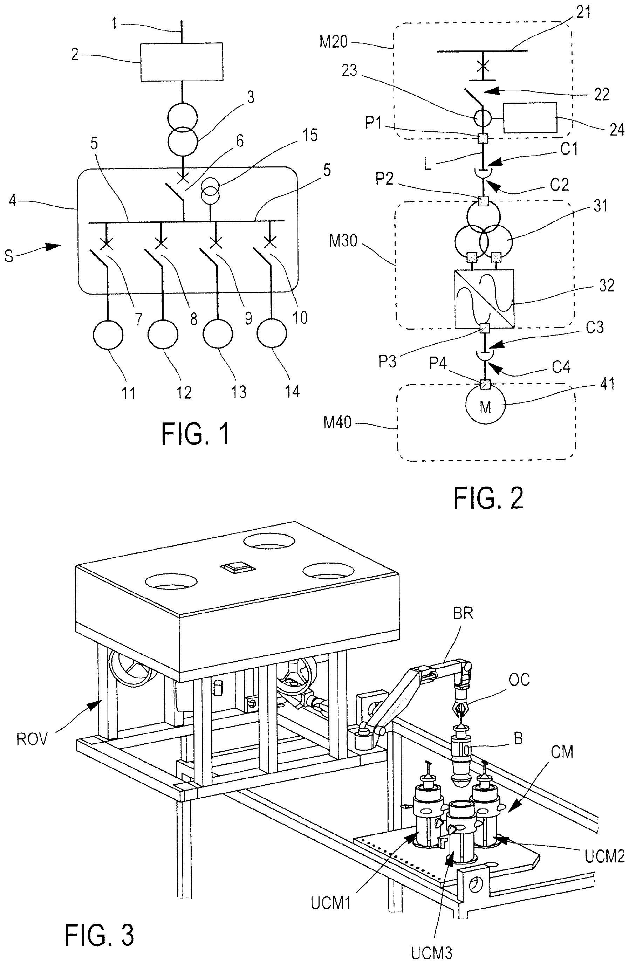

L'invention porte sur un procédé de localisation de défaut électrique dans un système modulaire de distribution électrique sous-marin dont la figure 1 donne une illustration schématique.

Sur cette figure 1, le système modulaire de distribution électrique sous-marin S comporte un module sous-marin de disjoncteur 4 qui reçoit la puissance électrique depuis une unité sous-marine de terminaison d'ombilical 2 couplée à un câble ombilical 1, après réduction dans le cas illustré par un transformateur abaisseur 3 par exemple configuré pour abaisser la tension de 100 kV à 33 kV.

Dans l'exemple de la figure 1, le module de disjoncteur 4 comprend cinq disjoncteurs 6-10. L'une des extrémités de chacun des disjoncteurs est connectée à un jeu de barres 5 et l'autre extrémité, dite extrémité libre, est couplée à une source de puissance ou à une charge selon la configuration désirée. Le disjoncteur 6 est ainsi agencé de manière à ce que son extrémité libre reçoive la puissance depuis le câble ombilical 1. L'extrémité libre de chacun disjoncteurs 7-10 est quant à elle couplée à un module sous-marin de charge 11-14. Le module de disjoncteur 4 peut par ailleurs comprendre un transformateur de tension 15 à des fins de supervision et de protection.

L'invention vise à permettre la localisation de défauts électriques le long d'une ligne de puissance entre le module de disjoncteur 4 et l'un des modules de charge 11-14. La figure 2 illustre un exemple d'une telle ligne de puissance L, la description du procédé selon l'invention étant par la suite faite en référence à cette figure 2.

On retrouve en amont de la ligne de puissance L un module sous-marin de tête de ligne M20 comportant un jeu de barres 21 qui comme le jeu de barres 5 de la figure 1 est destiné à recevoir la puissance électrique depuis un câble ombilical, un disjoncteur de tête de ligne 22 dont une extrémité est reliée au jeu de barres et dont l'autre extrémité est destinée à être couplée à une charge. Le module de tête de ligne M20 comporte par ailleurs un relais de protection 24 apte à déclencher l'ouverture du disjoncteur de tête de ligne 22, notamment en cas de défaut électrique détecté en aval sur la ligne L.

Dans un mode de réalisation, le relais de protection 24 est associé à un transformateur de courant 23 agencé pour mesurer le courant, de phase ou homopolaire, en aval du disjoncteur de tête de ligne 22, et est configuré pour comparer ce courant à un seuil afin d'identifier un défaut électrique en aval du disjoncteur sur la ligne et le signaler à une unité de contrôle du système de distribution électrique. Le relais de protection peut notamment intégrer une protection contre les défauts à la terre et les surintensités.

On trouve à la terminaison de la ligne de puissance L un module sous-marin de terminaison de ligne M40 qui comporte typiquement une charge 41 à qui la puissance doit être fournie, notamment une puissance supérieure à 100 kVA, par exemple le moteur d'une pompe de surpression ou d'un compresseur.

On peut par ailleurs trouver le long de la ligne un ou plusieurs modules sous-marins intermédiaires agencés en série entre le module de tête de ligne M20 et le module de terminaison de ligne M40. Dans l'exemple de la figure 2, on retrouve ainsi un module intermédiaire sous-marin M30 qui comprend un transformateur abaisseur 31 et un dispositif d'entraînement à fréquence variable 32 (VFD selon la terminologie anglo-saxonne « *Variable Frequency Drive* ») qui fournit une puissance électrique à fréquence variable au module de terminaison de ligne M40.

Dans un autre mode de réalisation, la détection d'un défaut électrique en aval du disjoncteur de tête de ligne n'est pas réalisée par le relais de protection du module de tête de ligne, mais par exemple par un module intermédiaire, tel que le module intermédiaire M30 de la figure 2 qui dispose alors de détecteurs de défauts électriques (typiquement défauts de terre et de surintensités) dans le module de terminaison de ligne. Dans un tel cas de figure, l'invention permet d'identifier quels sont les équipements défectueux en aval du module intermédiaire à détecteurs de défauts électriques.

On retrouve également le long de la ligne de puissance L un ensemble de connecteurs électriques C1-C4 raccordables sous l'eau qui permettent d'assurer la connexion des modules sous-marins deux à deux. Deux modules consécutifs sur la ligne L sont plus précisément connectés ensemble au moyen d'un connecteur mâle C1, C3 et d'un connecteur femelle C2, C4 (chaque connecteur, mâle ou femelle, comprenant généralement plusieurs unités de connexion, trois unités de connexion typiquement). Dans l'exemple de la figure 2, on retrouve ainsi un connecteur mâle C1 côté module de tête de ligne M20 qui peut être connecté à un connecteur femelle C2 côté module intermédiaire M30 pour assurer la connexion électrique du module de tête de ligne et du module intermédiaire. On retrouve par ailleurs un connecteur mâle C3 côté module intermédiaire M30 qui peut être connecté à un connecteur femelle C4 côté module de terminaison de ligne M40 pour assurer la connexion électrique du module intermédiaire et du module de terminaison de ligne. Chacun de ses connecteurs C1, C4 est agencé à l'extrémité d'un câble couplé au module respectif via un pénétrateur d'enceinte P1-P4.

Lorsqu'un défaut en aval du disjoncteur 22 sur la ligne est détecté, le procédé selon l'invention comporte une première étape consistant à procéder à l'ouverture du disjoncteur pour isoler le circuit, cette ouverture étant suivie par la déconnexion du connecteur mâle et du connecteur femelle assurant la connexion électrique entre deux modules sous-marins consécutifs sur la ligne. Cette déconnexion est typiquement réalisée par un véhicule sous-marin téléguidé ROV comme cela sera décrit plus en détail par la suite.

Dans une première mise en œuvre du procédé, on vient typiquement déconnecter le module de terminaison de ligne M40 du module qui lui est directement en amont sur la ligne, à savoir le module de tête de ligne M20 en l'absence de module intermédiaire ou un module intermédiaire M30 comme c'est le cas sur la figure 2. Comme détaillé par la suite, ceci permet en effet de vérifier si le défaut électrique provient du tronçon déconnecté de la ligne de puissance, à savoir si le défaut provient du module de terminaison de ligne M40 ou du câble à terminaison par connecteur femelle C4 qui le connecte au module qui lui est directement en amont sur la ligne. Lorsqu'il a été vérifié que le défaut ne provient pas du tronçon déconnecté, on vient réitérer le procédé en déconnectant cette fois les connecteurs mâle/femelle (les connecteurs C1, C2 connectant les modules de tête de ligne M20 et intermédiaire M30 dans l'exemple de la figure 2) directement en amont sur la ligne des connecteurs préalablement déconnectés. Ceci permet alors de vérifier si le défaut provient du module immédiatement en amont du module de terminaison de ligne ou du ou des câbles qui en sont issus (module intermédiaire M30 et câbles à terminaison par connecteurs C2, C3 dans l'exemple de la figure 2). Le procédé peut ainsi être réitéré jusqu'à remonter au module de tête de ligne M20.

Un connecteur mâle raccordable sous l'eau est relativement simple et correspond essentiellement à un contact électrique en cuivre, ou en un alliage de propriétés adaptées, qui se retrouve exposé à l'eau de mer lorsqu'il est déconnecté du connecteur femelle correspondant. Le connecteur femelle est quant à lui plus complexe et contient un fluide d'isolement qui permet d'éviter toute exposition à l'eau de mer lorsqu'il est déconnecté du connecteur mâle correspondant.

Dans une deuxième étape du procédé, on vient mettre en place un bouchon diélectrique sur le connecteur mâle déconnecté du connecteur femelle lors de la première étape. Ce bouchon diélectrique permet d'isoler le connecteur mâle de l'eau de mer et permet de mettre sous pleine tension la ligne de puissance jusqu'au connecteur mâle.

Cette deuxième étape est réalisée au moyen d'un véhicule sous-marin téléguidé ROV. Comme représenté sur la figure 3, le véhicule ROV comporte un bras BR à l'extrémité duquel est monté un outil de couple OC qui permet de venir mettre en place un bouchon diélectrique B sur un connecteur mâle UCM. Le connecteur mâle comprend ici trois unités de connexion mâles UCM1-UCM3, dont deux UCM1, UCM2 sont déjà isolées au moyen d'un bouchon diélectrique tandis qu'un bouchon diélectrique B est en train d'être installé sur la troisième unité UCM3. Une fois le bouchon installé, le véhicule ROV le bloque en position en venant le tourner de 90° par le même outil de couple OC.

Dans une troisième étape du procédé, on vient fermer le disjoncteur de tête de ligne 22 du module de tête de ligne M20. Reprenant l'exemple de la figure 2, et dans une première mise en œuvre du procédé, la fermeture du disjoncteur 22 après mise en place du bouchon sur le connecteur mâle C3 précédemment déconnecté permet d'appliquer la pleine tension du système à la portion de la ligne de puissance en amont du connecteur mâle C3 précédemment déconnecté.

Dans une quatrième étape du procédé, on vient vérifier, par exemple par le relais de protection 24, si un défaut en aval du disjoncteur de tête de ligne 22 est détecté.

En l'absence de détection d'un défaut en aval du disjoncteur de tête de ligne sur la ligne L, la présence d'un défaut est identifiée dans le module sous-marin de terminaison de ligne ou dans le câble reliant le module sous-marin de terminaison de ligne au connecteur femelle C4 apte à assurer la connexion électrique dudit module sous-marin de terminaison de ligne au module sous-marin situé directement en amont sur la ligne. On peut alors procéder au changement du seul module sous-marin de terminaison.

En cas de détection d'un défaut en aval du disjoncteur de tête de ligne sur la ligne L, ledit disjoncteur est ouvert, par exemple sur réception d'un signal d'ouverture du relais de protection, et la présence du défaut est alors identifiée en amont du connecteur mâle C3 déconnecté à la première étape.

En présence d'un ou plusieurs modules intermédiaires entre le module de tête de ligne et le module de terminaison de ligne, on peut également chercher à identifier celui des modules (ou du ou des câbles associés) en amont du module de terminaison qui présente le défaut électrique. Pour ce faire, on réitère tout d'abord les quatre étapes du procédé en substituant le module intermédiaire M30 au module de terminaison de ligne pour venir déconnecter ledit module intermédiaire du module qui lui est directement en amont sur la ligne (module de tête de ligne M20 dans l'exemple de la figure 2). On aura compris que les quatre étapes du procédé peuvent être réitérées tant que la quatrième étape conclut à la présence d'un défaut en aval du disjoncteur de tête de ligne en venant à chaque itération substituer à un module intermédiaire le module qui lui est directement en amont sur la ligne, et ce jusqu'à remonter au module de tête de ligne qui est alors déconnecté du module qui lui est directement en aval sur la ligne.

Dans un mode de réalisation, avant de procéder à la réitération des étapes du procédé, on vient retirer le bouchon mise en place lors de la deuxième étape précédente et procéder à la reconnexion des connecteurs mâle et femelle déconnectés lors de la première étape précédente.

Dans un mode de réalisation du procédé, celui-ci comporte entre les première et deuxième étapes décrites précédemment une étape consistant à amener le connecteur femelle d'une position de déconnexion en alignement dans laquelle le connecteur femelle est désengagée du connecteur mâle en alignement avec celui-ci vers une position de déconnexion distante, notamment un position distance dans laquelle le connecteur femelle est écartée du connecteur maie d'une distance suffisante pour permettre la mise en place lors de la deuxième étape du bouchon diélectrique sur le connecteur mâle, respectivement le retrait du bouchon diélectrique précédemment mis en place, par un véhicule sous-marin téléguidé ROV.

De telle manière, l'invention est parfaitement réalisable par un véhicule ROV, ce qui présente l'avantage de réduire de manière significative la durée nécessaire pour localiser le défaut, car la mise en œuvre de l'invention ne nécessite pas l'emploi d'un navire pour lequel la disponibilité et les conditions météorologiques peuvent souvent retarder les opérations pour plusieurs mois. Il en découle en outre une diminution du risque d'endommagement des modules sous-marins et des câbles d'interconnexion formant le système modulaire de distribution électrique sous-marin. En outre, l'invention ne nécessite pas de capteurs ou d'équipement de puissance additionnels, évitant de la sorte l'introduction de modes de défaillance additionels qui pourraient réduire la disponibilité du système modulaire de distribution électrique sous-marin.

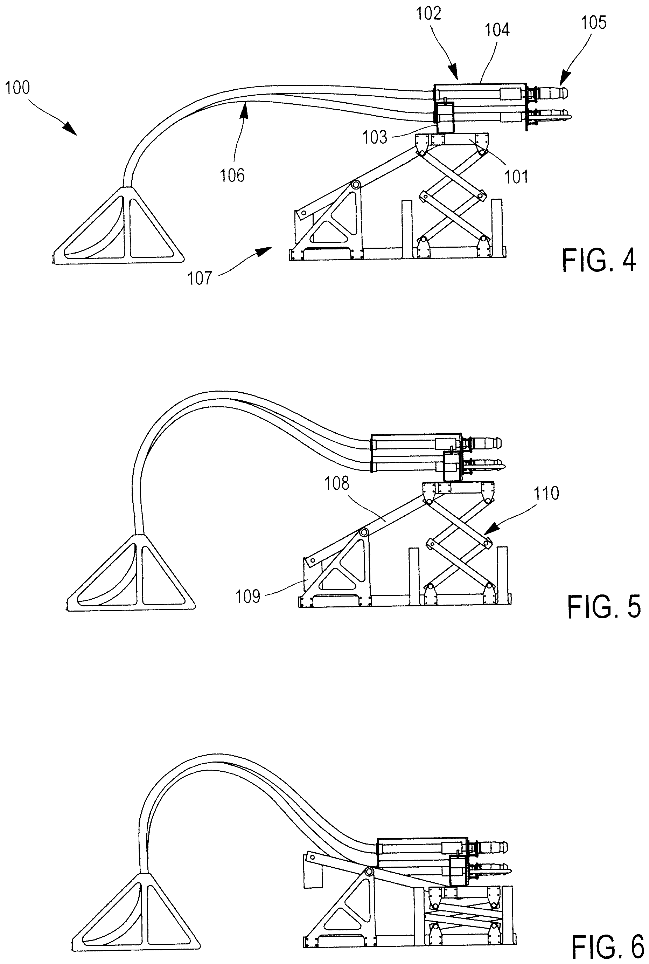

On a représenté sur les figures 4-6 un dispositif 100 de connexion de câble à terminaison par connecteur femelle pour système modulaire de distribution électrique sous-marin pouvant être utilisé dans le cadre de l'invention en particulier pour amener le connecteur femelle dans une position distante où il est suffisamment écarté du connecteur mâle pour permettre la mise en place et le retrait du bouchon diélectrique par un véhicule ROV.

Le dispositif 100 comporte un châssis 101, une platine de support de terminaison de câble 102 comprenant une portion fixe 103 liée au châssis et une portion mobile 104 pouvant être déplacée en translation relativement au châssis 101 de manière à pouvoir déplacer le connecteur femelle 105 (qui comporte plusieurs unités de connexion femelle) à la terminaison du câble 106 (en réalité un câble par unité de connexion femelle) entre une position de service dans laquelle le connecteur femelle et un connecteur mâle sont connectés et une position de déconnexion en alignement dans laquelle le connecteur femelle est désengagée du connecteur mâle en alignement avec celui-ci. La figure 4 illustre à ce propos le dispositif 100 avec le connecteur femelle 105 en position de service (le connecteur mâle censé se trouver à droite sur la figure n'étant pas représenté). La figure 5 illustre quant à elle le dispositif 100 avec le connecteur femelle 105 en position de déconnexion en alignement, après recul de la portion mobile 104.

Le passage entre les positions de service et de déconnexion en alignement peut notamment être assuré par un véhicule ROV qui vient avancer/reculer la portion mobile 105 de la platine de support de terminaison de câble 102.

Le dispositif 100 de connexion de câble à terminaison par connecteur femelle comporte par ailleurs un support de châssis manœuvrable 107 pour permettre le déplacement du connecteur femelle entre la position de déconnexion en alignement représentée sur la figure 5 et une position de déconnexion distante représentée sur la figure 6. Dans le mode de réalisation représenté sur la figure 6, ladite position de déconnexion distante est une position abaissée dans laquelle le connecteur femelle n'est plus au droit du connecteur.

Le support de châssis manœuvrable 107 comporte par exemple un bras de levier 108 à une extrémité duquel est positionné un contrepoids 109 et à l'autre extrémité duquel est monté le châssis 101. Il comporte par ailleurs un dispositif de levage 110 soutenant le châssis, pouvant être rétracter/allonger pour abaisser/relever le châssis et ainsi amener le connecteur femelle en position de déconnexion distante/position de déconnexion en alignement. Le passage entre les positions de déconnexion en alignement et de déconnexion distante peut notamment être assuré par un véhicule ROV. Dans un mode de réalisation possible, le dispositif de levage 110 comporte une vis sans fin qui peut être mise en rotation par l'outil de couple OC d'un véhicule ROV afin de retracter/abaisser le dispositif de levage et ainsi abaisser/relever le châssis 101.

Le dispositif 100 de connexion de câble à terminaison par connecteur femelle est avantageux dans la mesure où la mise en position distante peut être réalisée par un véhicule ROV, alors qu'un tel véhicule ne peut supporter les poids considérables mis en jeu dans les systèmes de distribution électrique sous-marin (chaque module fait plus d'une tonne - les câbles eux-mêmes ont une section supérieure à 50 mm², classiquement de l'ordre d'une centaine de mm²). La section importante des câbles impose par ailleurs des longueurs suffisantes pour les changements de direction, les rayons de courbure de ces câbles ne pouvant être inférieurs à des valeurs définies pour éviter les dommages. Le recours à un dispositif de connexion de câble permet de respecter les tangences minimes en usage, le dispositif selon l'invention permettant en outre de pouvoir suffisamment écarter le câble à terminaison femelle du connecteur mâle pour permettre la mise en place, respectivement le retrait, du bouchon diélectrique sur le connecteur mâle par un véhicule ROV.

## Revendications

1. Procédé de localisation de défaut électrique dans un système modulaire de distribution électrique sous-marin (S) comprenant une ligne de puissance (L) le long de laquelle sont disposés :
- un module sous-marin de tête de ligne (M20) comprenant un disjoncteur (22) et un relais de protection (24) configuré pour détecter un défaut électrique en aval du disjoncteur sur la ligne ;
- un module sous-marin de terminaison de ligne (M40) ;
- optionnellement, un ou plusieurs modules sous-marins intermédiaires (M30) en série entre le module sous-marin de tête de ligne et le module sous-marin de terminaison de ligne ;
- un ensemble de connecteurs électriques (C1-C4) raccordables sous l'eau permettant d'assurer la connexion électrique des modules sous-marins (M20, M30, M40) le long de la ligne, un connecteur mâle (C1, C3) et un connecteur femelle (C2, C4) assurant la connexion électrique entre deux modules sous-marins consécutifs le long de la ligne, le procédé étant **caractérisé en ce qu'**il comprend les étapes suivantes mises en œuvre après ouverture du disjoncteur du module sous-marin de tête de ligne suite à la détection d'un défaut électrique en aval sur la ligne :
a) déconnexion par un véhicule sous-marin téléguidé du connecteur mâle et du connecteur femelle assurant la connexion électrique entre deux modules sous-marins consécutifs sur la ligne ;
b) mise en place d'un bouchon diélectrique sur le connecteur mâle déconnecté du connecteur femelle par un véhicule sous-marin téléguidé ;
c) fermeture du disjoncteur du module sous-marin de tête de ligne ;
d) vérification d'une détection d'un défaut sur la ligne en aval du disjoncteur du module de tête de ligne.

2. Procédé selon la revendication 1, dans lequel l'étape a) comprend la déconnexion du connecteur mâle (C3) et du connecteur femelle (C4) assurant la connexion électrique entre le module sous-marin de terminaison de ligne (M40) et le module sous-marin (M30) qui lui est situé directement en amont sur la ligne.

3. Procédé selon la revendication 2, dans lequel le module sous-marin situé directement en amont sur la ligne du module sous-marin de terminaison de ligne (M40) est le module sous-marin de tête de ligne.

4. Procédé selon la revendication 2, dans lequel le module sous-marin situé directement en amont sur la ligne du module sous-marin de terminaison de ligne (M40) est un module sous-marin intermédiaire (M30).

5. Procédé selon la revendication 4, dans lequel lorsque l'étape d) conclut à la présence d'un défaut sur la ligne en aval du disjoncteur du module de tête de ligne, on réitère les étapes a) à d) en substituant ledit module sous-marin intermédiaire (M30) au module sous-marin de terminaison de ligne (M40) pour venir déconnecter ledit module sous-marin intermédiaire (M30) du module sous-marin (M20) qui lui est situé directement en amont sur la ligne.

6. Procédé selon la revendication 5, dans lequel les étapes a) à d) sont réitérées tant que l'étape d) conclut à la présence d'un défaut sur la ligne en aval du disjoncteur du module de tête de ligne en venant à chaque itération substituer au module sous-marin intermédiaire le module sous-marin qui lui est situé directement en amont sur la ligne.

7. Procédé selon l'une des revendications 5 ou 6 comprenant, avant réitération des étapes a) à d), le retrait du bouchon diélectrique mis en place sur le connecteur mâle lors de l'étape b) et la reconnexion du connecteur mâle et du connecteur femelle déconnectés lors de l'étape a).

8. Procédé selon l'une des revendications précédentes, comprenant entre les étapes a) et b) une étape consistant à amener le connecteur femelle d'une position de déconnexion en alignement dans laquelle le connecteur femelle est désengagée du connecteur mâle en alignement avec celui-ci vers une position de déconnexion distante.

## Patentansprüche

1. Verfahren zur Ortung eines elektrischen Fehlers in einem modularen Unterwasser-Stromverteilungssystem (S), das eine Leistungsleitung (L) beinhaltet, entlang derer Folgendes angeordnet ist:
- ein Unterwassermodul am Anfang der Leitung (M20), das einen Schalter (22) und ein Schutzrelais (24), das dazu konfiguriert ist, einen elektrischen Fehler stromabwärts des Schalters in der Leitung zu erkennen, beinhaltet;
- ein Unterwassermodul am Ende der Leitung (M40);
- optional ein oder mehrere Unterwasser-Zwischenmodule (M30) in Reihe zwischen dem Unterwassermodul am Anfang der Leitung und dem Unterwassermodul am Ende der Leitung;
- eine Gesamtheit von elektrischen Steckverbindern (C1-C4), die unter Wasser anschließbar sind und das Sicherstellen der elektrischen Verbindung der Unterwassermodule (M20, M30, M40) entlang der Leitung ermöglichen, wobei ein Stecker (C1, C3) und eine Buchse (C2, C4) die elektrische Verbindung zwischen zwei aufeinanderfolgenden Unterwassermodulen entlang der Leitung sicherstellen,
wobei das Verfahren **dadurch gekennzeichnet ist, dass** es die folgenden Schritte beinhaltet, die nach dem Öffnen des Schalters des Unterwassermoduls am Anfang der Leitung im Anschluss an die Erkennung eines elektrischen Fehlers stromabwärts in der Leitung umgesetzt werden:
a) Trennen, durch ein ferngesteuertes Unterwasserfahrzeug, des Steckers und der Buchse, die die elektrische Verbindung zwischen zwei aufeinanderfolgenden Unterwassermodulen in der Leitung sicherstellen;
b) Anbringen einer dielektrischen Kappe auf dem von der Buchse getrennten Stecker mit Hilfe eines ferngesteuerten Unterwasserfahrzeugs;
c) Schließen des Schalters des Unterwassermoduls am Anfang der Leitung;
d) Prüfen, ob ein Fehler in der Leitung stromabwärts des Schalters des Moduls am Anfang der Leitung erkannt wird.

2. Verfahren nach Anspruch 1, wobei der Schritt a) das Trennen des Steckers (C3) und der Buchse (C4), die die elektrische Verbindung zwischen dem Unterwassermodul am Ende der Leitung (M40) und dem Unterwassermodul (M30), das sich in der Leitung direkt stromaufwärts von diesem befindet, sicherstellen, beinhaltet.

3. Verfahren nach Anspruch 2, wobei das Unterwassermodul, das sich in der Leitung direkt stromaufwärts des Unterwassermoduls am Ende der Leitung (M40) befindet, das Unterwassermodul am Anfang der Leitung ist.

4. Verfahren nach Anspruch 2, wobei das Unterwassermodul, das sich in der Leitung direkt stromaufwärts des Unterwassermoduls am Ende der Leitung (M40) befindet, ein Unterwasser-Zwischenmodul (M30) ist.

5. Verfahren nach Anspruch 4, wobei, wenn in Schritt d) auf das Vorhandensein eines Fehlers in der Leitung stromabwärts des Schalters des Moduls am Anfang der Leitung geschlossen wird, die Schritte a) bis d) wiederholt werden, wobei das Unterwassermodul am Ende der Leitung (M40) durch das Unterwasser-Zwischenmodul (M30) ersetzt wird, um das Unterwasser-Zwischenmodul (M30) von dem Unterwassermodul (M20), das sich in der Leitung direkt stromaufwärts von diesem befindet, zu trennen.

6. Verfahren nach Anspruch 5, wobei die Schritte a) bis d) wiederholt werden, solange in Schritt d) auf das Vorhandensein eines Fehlers in der Leitung stromabwärts des Schalters des Moduls am Anfang der Leitung geschlossen wird, wobei bei jeder Wiederholung das Unterwasser-Zwischenmodul durch das Unterwasser-Zwischenmodul, das sich in der Leitung direkt stromaufwärts von diesem befindet, ersetzt wird.

7. Verfahren nach einem der Ansprüche 5 oder 6, das vor dem Wiederholen der Schritte a) bis d) das Entfernen der dielektrischen Kappe, die während des Schritts b) auf dem Stecker angebracht wurde, und das Wiederverbinden des Steckers und der Buchse, die während des Schritts a) getrennt wurden, beinhaltet.

8. Verfahren nach einem der vorhergehenden Ansprüche, das zwischen den Schritten a) und b) einen Schritt beinhaltet, der darin besteht, die Buchse von einer ausgerichteten Trennposition, in der die Buchse von dem Stecker gelöst, jedoch zu diesem ausgerichtet ist, in eine beabstandete Trennposition zu bringen.

## Claims

1. Method for localizing an electrical fault in a modular submarine electrical distribution system (S), comprising a power line (L) along which the following are arranged:
- a submarine line head module (M20) comprising a circuit breaker (22) and a protective relay (24) configured in order to detect an electrical fault downstream of the circuit breaker on the line;
- a submarine line termination module (M40);
- optionally, one or more intermediate submarine modules (M30) in series between the submarine line head module and the submarine line termination module;
- a set of underwater-connectable electrical connectors (C1-C4), making it possible to electrically connect the submarine modules (M20, M30, M40) along the line, a male connector (C1, C3) and a female connector (C2, C4) providing the electrical connection between two consecutive submarine modules along the line,
the method being **characterized in that** it comprises the following steps carried out after opening of the circuit breaker of the submarine line head module following the detection of an electrical fault downstream on the line:
a) disconnection by a remotely operated submarine vehicle of the male connector and the female connector providing the electrical connection between two consecutive submarine modules along the line;
b) fitting of a dielectric plug on the male connector disconnected from the female connector by a remotely operated submarine vehicle;
c) closure of the circuit breaker of the submarine line head module;
d) verification of detection of a fault on the line downstream of the circuit breaker of the line module.

2. Method according to Claim 1, wherein step a) comprises disconnection of the male connector (C3) and of the female connector (C4) providing the electrical connection between the submarine line termination module (M40) and the submarine module (M30) which is located directly upstream thereof on the line.

3. Method according to Claim 2, wherein the submarine module located directly upstream of the submarine line termination module (M40) on the line is the submarine line head module.

4. Method according to Claim 2, wherein the submarine module located directly upstream of the submarine line termination module (M40) on the line is an intermediate submarine module (M30).

5. Method according to Claim 4, wherein when step d) concludes that there is a fault on the line downstream of the circuit breaker of the line head module, steps a) to d) are repeated while substituting said intermediate submarine module (M30) for the submarine line termination module (M40) for disconnecting said intermediate submarine module (M30) from the submarine module (M20) which is located directly upstream thereof on the line.

6. Method according to Claim 5, wherein steps a) to d) are repeated so long as step d) concludes that there is a fault on the line downstream of the circuit breaker of the line head module, while at each iteration substituting for the intermediate submarine module the submarine module which is located directly upstream thereof on the line.

7. Method according to either of Claims 5 and 6, comprising, before repetition of steps a) to d), removal of the dielectric plug fitted on the male connector during step b) and reconnection of the male connector and the female connector which were disconnected during step a).

8. Method according to one of the preceding claims, comprising, between steps a) and b), a step consisting in bringing the female connector from a disconnection position in alignment, in which the female connector is disengaged from the male connector in alignment therewith, to a remote disconnection position.
